# EUROPEAN PATENT APPLICATION

(11) **EP 4 553 805 A1**
(43) Date of publication of application: **14.05.2025**
(21) Application number: 24170233.1
(22) Date of filing: 15.04.2024
(51) Int. Cl.: G08C 23/02

(54) **WAKE-UP APPARATUS AND METHOD FOR WIRELESS BATTERY MANAGEMENT SYSTEM**

(30) Priority: 13.11.2023 KR 20230156518
(71) Applicant: Samsung SDI Co., Ltd., Yongin-si, Gyeonggi-do 17084 (KR)
(72) Inventor: Kim, Min Su, 16678 Suwon-si, Gyeonggi-do (KR)
(74) Representative: Gulde & Partner

(57) **Abstract**

Disclosed herein are wake-up apparatus and method of a wireless battery management system, which can wake-up a slave node of a wireless battery management system in a standby state using a sound wave and include a master radio frequency (RF) node configured to output a resonant sound wave with a specified frequency and a specified digital signal pattern and a slave RF node which wakes up upon receiving the resonant sound wave output from the master RF node.

## Description

### BACKGROUND

### 1. Field

The present invention relates to a wake-up apparatus and method for a wireless battery management system (BMS).

### 2. Description of the Related Art

Generally, a battery management system (BMS) is a device that monitors a status of a battery pack and controls a battery to operate safely and efficiently.

The BMS tracks important parameters such as a power level, a temperature, and a state of charge and uses this information to extend the overall lifetime of the battery and reduce the risks of over-heating, over-charging, and over-discharging of the battery.

Battery packs are used in a variety of applications such as electric vehicles, renewable energy storage systems, wireless power tools, and drones.

In these applications, the BMS play a critical role and is essential to secure an efficient and safe battery operation.

The existing BMS communicates with a battery set through wired communication, but the wired communication is complicated to install and maintain and has a limitation in reliability and flexibility of the existing BMS. Thus, a wireless BMS is recently getting attention.

However, it is important to consider power consumption optimization in the wireless BMS, and slave nodes in the wireless BMS have a disadvantage of consuming power because the slave nodes should periodically monitor a wake-up signal from a master node even in a standby state.

Thus, there is a need for a method of reducing power consumption even when the slave nodes of the wireless BMS are in a standby state.

The above-described information disclosed in the technology that forms the background of the present invention is only intended to improve understanding of the background of the present invention, and thus may include information that does not constitute the related art.

### SUMMARY

The present invention is directed to providing a wake-up apparatus and method for a wireless battery management system (BMS), which can wake-up a slave node of a wireless BMS in a standby state using a sound wave.

The present invention is also directed to providing a wake-up apparatus and method for a wireless BMS, which can improve a power consumption optimization function of a wireless BMS through a low-power wake-up using a sound wave.

However, technical objects to be achieved by the present invention are not limited to the above-described objects, and other objects that are not mentioned can be clearly understood by those skilled in the art from the following description of the present invention.

According to an aspect of the present invention, there is provided a wake-up apparatus for a wireless BMS, which includes a master radio frequency (RF) node configured to output a resonant sound wave with a specified frequency and a specified digital signal pattern, and a slave RF node which wakes up upon receiving the resonant sound wave output from the master RF node.

A resonant sound wave may be detected with less energy than a RF signal. Accordingly, the function of waking a slave may be performed more energy efficient. Furthermore, a wireless communication requires less effort to be set up, that is, a high degree of flexibility exists.

According to one embodiment, the master RF node includes a sound wave output module configured to output the resonant sound wave with the specified frequency and the specified digital signal pattern under control of a first processor.

In other words, the sound wave output module controls the sound wave. That is, the sound wave output module may control the sound wave such that the sound wave arrives at the slave RF node. The frequency is also selected such that the sound wave arrives at the slave RF node.

According to one embodiment, the slave RF node includes a sound wave reception module configured to receive the resonant sound wave output from the master RF node.

The sound wave reception module may be configured such that the sound wave can be detected.

According to one embodiment, the sound wave reception module is a sensor configured to convert the received resonant sound wave into an electrical signal and output the electrical signal and includes a piezo sensor.

According to one embodiment, the slave RF node includes a second processor configured to analyze whether the electrical signal converted from the resonant sound wave received through the sound wave reception module is a wake-up signal for waking up a second RF module of the slave RF node.

In other words, the second processor may switch between sound wave communication and RF wave communication.

According to one embodiment, the wake-up signal includes a signal pattern of a first period (wake period) for releasing a low-power state of the second processor of the slave RF node; and a signal pattern of a second period (validation period) for wake-up command authentication of the second RF module of the slave RF node.

In other words, releasing the low-power state may refer to changing the power state of the processor. In particular, changing the power state from a low-power state to a non-low-power state.

According to one embodiment, the second processor is configured to monitor the signal pattern of the first period (wake period) of the electrical signal converted from the resonant sound wave received through the sound wave reception module in a low-power state and releases the low-power state when the signal pattern is recognized as a normal pattern; and monitor the signal pattern of the second period (validation period), determines the electrical signal to be the wake-up signal for waking up the second RF module of the slave RF node when the signal pattern is recognized as a normal pattern, and wake up the second RF module of the slave RF node.

When the electrical signal is not determined as the wake-up signal, the electrical signal is ignored. The normal pattern may refer to a known pattern.

According to one embodiment, the low-power state includes a low-power mode operating state of the second processor or an operating state using a low-power core.

The low-power mode operating state of the second processor or the operating state using a low-power core may save energy compared to other power mode operating states or non-low-power cores, respectively.

According to an aspect of the invention, the wake-up method of a wireless battery management system, comprises outputting, by a master radio frequency (RF) node of a wireless battery management system, a resonant sound wave with a specified frequency and a specified digital signal pattern; and receiving, by a slave RF node, the resonant sound wave output from the master RF node to wake up.

According to one embodiment, in the outputting of the resonant sound wave, a first processor of the master RF node controls a sound wave output module to output the resonance sound wave with the specified frequency and the specified digital signal pattern.

That is, the sound wave output module may control the sound wave such that the sound wave arrives at the slave RF node. The soundwave output module may transform an electrical signal from the first processor into the sound wave. The transformation may be performed by a piezo actuator.

According to one embodiment, in the receiving of the resonant sound wave, a second processor of the slave RF node receives the resonance sound wave output from the master RF node through a sound wave reception module.

According to one embodiment, the sound wave reception module is a sensor configured to convert the received resonant sound wave into an electrical signal and output the electrical signal and includes a piezo sensor.

A piezo sensor has the advantage that not only the signal itself but also energy can be transferred.

According to one embodiment, the receiving of the resonant sound wave to wake up includes analyzing, by a second processor of the slave RF node, whether an electrical signal converted from the resonant sound wave received through the sound wave reception module is a wake-up signal for waking up a second RF module of the slave RF node.

According to one embodiment, the wake-up signal includes a signal pattern of a first period (wake period) for releasing a low-power state of the second processor of the slave RF node; and a signal pattern of a second period (validation period) for wake-up command authentication of the second RF module of the slave RF node.

According to one embodiment, the receiving of the resonant sound wave to wake up includes monitoring, by the second processor, the signal pattern of the first period (wake period) of the electrical signal converted from the resonant sound wave received through the sound wave reception module in a low-power state and releasing the low-power state when the signal pattern is recognized as a normal pattern; and monitoring, by the second processor, the signal pattern of the second period (validation period), determines the electrical signal to be the wake-up signal for waking up the second RF module of the slave RF node when the signal pattern is recognized as a normal pattern, and waking up the second RF module of the slave RF node.

### BRIEF DESCRIPTION OF DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:
FIG. 1 is an exemplary diagram illustrating a schematic configuration of a wake-up apparatus for a wireless battery management system (BMS) according to one embodiment of the present invention;
FIG. 2 is an exemplary diagram illustrating a configuration of a wake-up signal (or command) according to one embodiment of the present invention;
FIG. 3 is an exemplary flowchart for describing a wake-up method of a wireless BMS according to a first embodiment of the present invention; and
FIG. 4 is an exemplary flowchart for describing a wake-up method of a wireless BMS according to a second embodiment of the present invention.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that one or more components may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

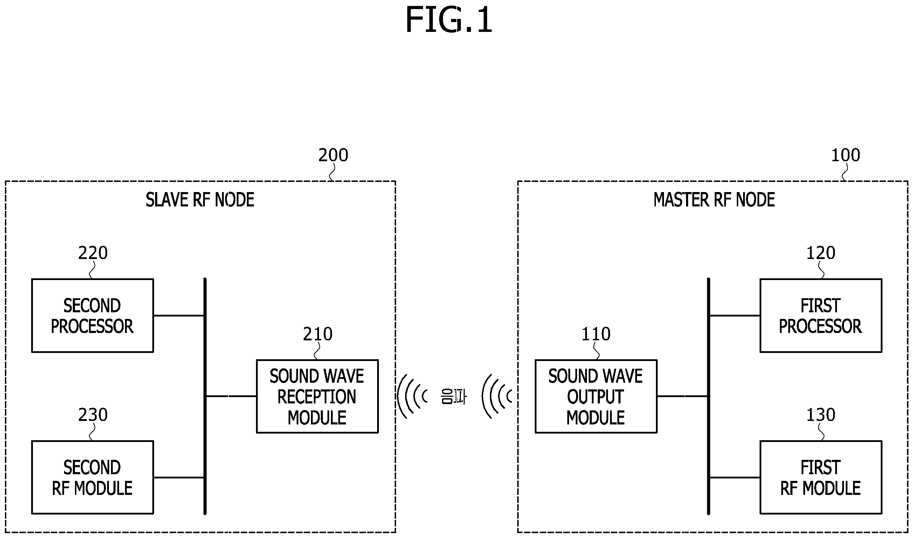

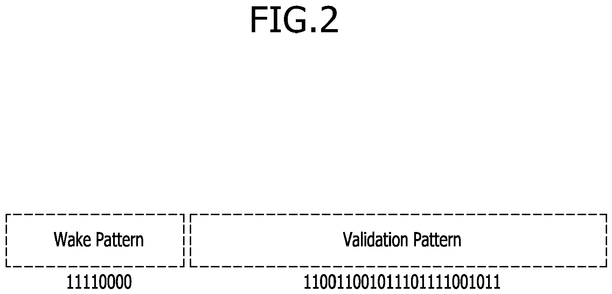

FIG. 1 is an exemplary diagram illustrating a schematic configuration of a wake-up apparatus for a wireless battery management system (BMS) according to one embodiment of the present invention. FIG. 2 is an exemplary diagram illustrating a configuration of a wake-up signal (or command) according to one embodiment of the present invention.

Referring to FIG. 1, the wireless BMS according to the present embodiment may include a master radio frequency (RF) node 100 and a plurality of slave RF nodes 200.

For example, the master RF node 100 and the plurality of slave RF nodes 200 may be implemented in a battery pack case made of an aluminum alloy.

The master RF node 100 may include a sound wave output module 110, a first processor 120, and a first RF module 130.

The slave RF node 200 may include a sound wave reception module 210, a second processor 220, and a second RF module 230.

The sound wave output module 110 outputs (emits) a resonant sound wave with a specified frequency and a specified digital signal pattern under the control of the first processor 120.

For example, the sound wave output module 110 of the master RF node 100 may output (emit) a resonant sound wave with a frequency of 40 kHz and a specified digital pattern. Alternatively, the frequency may be any one between 1 kHz and 100 kHz, preferably between 20 kHz and 70 kHz, more preferably between 35 and 50 kHz. Optionally, the frequency may be selected such that dampening of the signal during travel to the slave RF node is minimized. Optionally, different frequencies may be used for different slave RF nodes. Thereby, the requirements for detecting the sound wave may be further reduced. In this case, the specified frequency and the specified digital signal pattern, which are applied to the sound wave (resonant sound wave) output from the sound wave output module 110, have an effect of providing robustness by distinguishing the sound wave (resonant sound wave) from naturally occurring sound waves (i.e., external noise).

The first processor 120 may control the sound wave output module 110 to periodically or non-periodically output (emit) a resonant sound wave (hereinafter, it may be referred to as a designated resonant sound wave) with a specified frequency and a specified digital signal pattern.

The first RF module 130 may perform RF communication with the plurality of slave RF nodes 200. The first RF module 130 may be activated only when performing the RF communication with any one of the plurality of slave RF nodes 200 or may be activated always.

The sound wave reception module 210 of the slave RF node 200 receives the resonant sound wave output (emitted) from the sound wave output module 110 of the master RF node 100.

The sound wave reception module 210 includes a sensor (e.g., piezo sensor) capable of receiving sound waves. For example, the sensor capable of receiving sound waves (e.g., piezo sensor) detects a sound wave (or resonant sound wave) output (emitted) from the sound wave output module 110 of the master RF node 100, converts the detected sound wave into an electrical signal, and outputs the electrical signal.

The second processor 220 analyzes whether the signal output from the sound wave reception module 210 (i.e., the electrical signal converted from the detected sound wave) is a wake-up signal (or command) for waking up the second RF module 230 of the slave RF node 200.

For example, as shown in FIG. 2, the form of a wake-up signal (or command) for waking up the second RF module 230 of the slave RF node 200 may be implemented in a form including a "wake pattern" and "validation pattern."

However, it is noted that the form of the wake-up signal (or command) as shown in FIG. 2 in the present embodiment is only an example to help with understanding the present disclosure and is not intended to be limiting. For example, instead of "11110000", "10101010" or "11111111" or "11111100" or repetitions thereof may be used as the wake-up signal.

When analyzing the signal output from the sound wave reception module 210 (i.e., the electrical signal converted from the detected sound wave), in a low-power state, the second processor 220 monitors the signal pattern of a first period (wake period) of the electrical signal converted from the received sound wave, and when the signal pattern is recognized as a normal (i.e., specified) pattern, the low-power state is changed. In other words, the low-power state may be switched to a non-low-power state.

Here, the concept of the low-power state includes a low-power mode operating state of the second processor 220 and/or an operating state using a low-power core. The low power core may be or may include an application specific integrated circuit (ASIC) optimized for the detection of said wake pattern.

Then, when the second processor 220 monitors the signal pattern of a second period (validation period) of the electrical signal converted from the received sound wave and recognizes the signal pattern as a normal (i.e., specified) pattern, the second processor 220 determines the signal to be a wake-up signal (or command) for waking up the second RF module 230 of the slave RF node 200. Thereby, the second RF module may only be activated when required, saving energy.

As the result of analyzing the signal output from the sound wave reception module 210 (i.e., the electrical signal converted from the detected sound wave), when it is determined that the signal is the wake-up signal (or command) for waking up the second RF module 230 of the slave RF node 200, the second processor 220 wakes up the second RF module 230 of the slave RF node 200. Alternatively, when the signal is not the wake-up signal, the signal is ignored and no action is taken, thereby saving energy.

Referring to FIG. 2, the wake-up signal (or command) according to one embodiment of the present invention may include signal patterns of the first period (wake period) and the second period (validation period).

For example, when assuming that the signal pattern of the first period (wake period) is "11110000" (for convenience, a binary code "F" is expressed in ASCII) and the signal pattern of the second period (validation period) is "110011001011101111001011" (for convenience, a binary code "CBE" is expressed in ASCII), the entire signal pattern becomes "11110000110011001011101111001011."

However, as described above, the form of the wake-up signal (or command) as shown in FIG. 2 is only an exemplary form and may be implemented only with the signal pattern of the first period, that is the wake pattern, or with a signal pattern including two periods, that is the wake patter and the validation pattern, or more than two periods, for example further specifying an address of a slave RF node .

Thus, in the low-power state, the second processor 220 monitors only the signal pattern (e.g., 11110000) of the first period (wake period) of the electrical signal converted from the received sound wave, and when the signal pattern is recognized as a normal (i.e., specified) pattern, the low-power state is initiated. Optionally, the wake period triggers a second low-power state capable of processing the to-be-expected validation pattern. The second low-power state may have the same or a higher power consumption compared to the first low-power state for detecting the wake pattern.

Then, when the second processor 220 monitors the signal pattern of the second period (validation period) of the electrical signal converted from the received sound wave and recognizes the signal pattern as a normal (i.e., specified) pattern (e.g., 110011001011101111001011), the second processor 220 determines the signal to be a wake-up signal (or command) for waking up the second RF module 230 of the slave RF node 200 and wakes up the second RF module 230 of the slave RF node 200.

Thus, in the present embodiment, the recognition accuracy of the wake-up signal (or command) can be improved while reducing (and/or optimizing) power consumption of the second processor 220 (and/or the slave RF node).

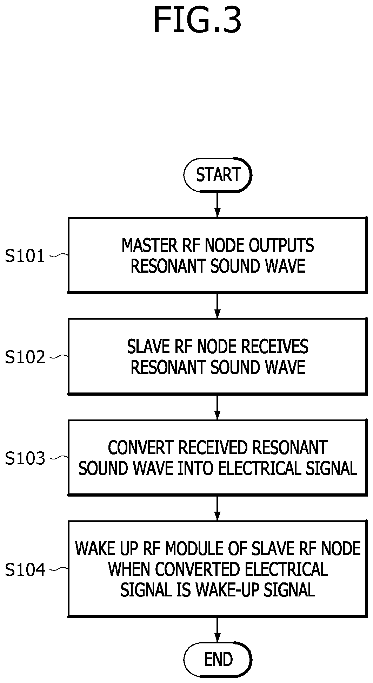

FIG. 3 is a flowchart for describing a wake-up method of a wireless BMS according to a first embodiment of the present invention. The descriptions regarding Figs. 1 and 2 apply accordingly.

Referring to FIG. 3, the first processor 120 of the master RF node 100 outputs (emits) a sound wave (resonant sound wave) with a specified frequency and a specified digital pattern through the sound wave output module 110 (S101).

The second processor 220 of the slave RF node 200 receives the sound wave (resonant sound wave) output (emitted) from the master RF node 100 through the sound wave reception module 210 (S102).

The sound wave reception module 210 of the slave RF node 200 converts the received sound wave (resonant sound wave) into an electrical signal (S103). The electrical signal converted by the sound wave reception module 210 is output to the second processor 220. The second processor 220 may process the electrical signal.

When the signal output from the sound wave reception module 210 (i.e., the electrical signal converted from the detected sound wave) is a wake-up signal (or command) for waking up the second RF module 230 of the slave RF node 200, the second processor 220 of the slave RF node 200 wakes up the second RF module 230 of the slave RF node 200 (S104).

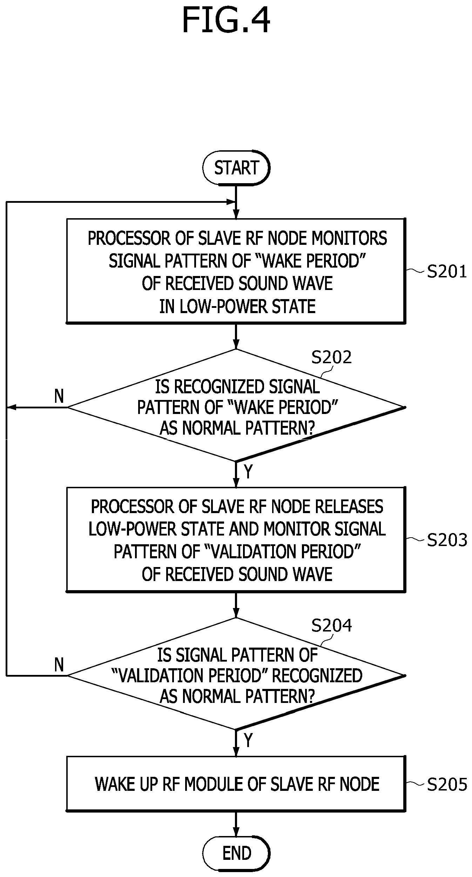

FIG. 4 is a flowchart for describing a wake-up method of a wireless BMS according to a second embodiment of the present invention. The descriptions regarding Figs. 1 and 2 apply accordingly.

In a low-power state, the second processor 220 of the slave RF node 200 monitors a signal pattern of a first period (wake period) of the signal output through the sound wave reception module 210 (i.e., the electrical signal converted from the detected sound wave) (S201).

As the result of the monitoring (S201), when the signal pattern of the first period (wake period) is recognized as a normal (i.e., specified) pattern (Y in S202), the second processor 220 releases the low-power state and monitors a signal pattern of a second period (validation period) of the electrical signal converted from the received sound wave (S203). In other words, releasing the low-power state may refer to changing the power state of the processor. In particular, changing the power state from a low-power state to a non-low-power state.

As the result of the monitoring (S203), the signal pattern of the second period (validation period) is recognized as a normal (i.e., specified) pattern (Y in S204), the second processor 220 determines the received sound wave to be a wake-up signal (or command) for waking up the second RF module 230 of the slave RF node 200 and wakes up the second RF module 230 of the slave RF node 200 (S205).

Therefore, in the present embodiment, the sum of power consumed by the second processor 220 and the sound wave reception module 210 is at a level of several microwatts (µW) so that it can be seen that the power consumption can be significantly reduced compared to the existing level of several milliwatts (mW). Specifically, the power consumption may be between 10 µW to 100 µW, preferably between 20 µW to 60 µW, more preferably between 30 µW to 40 µW.

For example, in the present embodiment, by using the sound wave reception module 210 (e.g., a piezo sensor), a simplified circuit configuration is possible compared to the existing RF transmission/reception circuits, and since complicated modulation/demodulation processes such as RF transmitting/receiving circuits are not present, power consumption is low, and communication is performed over a short distance using the characteristics of sound waves so that power consumption is low, and the sound wave is converted into electrical energy using vibrations and/or pressure change so that no separate power supply is required (or only a very small amount of power is required). The vibrations and/or pressure change may occur and/orrefer to the surface of the sensor. In addition, since the electrical signal converted from a sound wave can be read immediately, there is an advantage that a signal processing process consuming a lot of power is unnecessary. Thus, power of several mW is consumed for wake-up using the existing RF communication, but in the present embodiment, the recognition accuracy of the wake-up signal (or command) can be improved while consuming only power of several µW.

Hereinafter, an effect of the present invention will be described in more detail compared to the existing wake-up method through RF communication.

First, the existing wake-up method requires the slave RF node to periodically monitor the RF signal from the master RF node so that there is a problem of requiring constant power consumption even in a standby state. However, in the present invention, when the master node outputs (emits) a resonant sound wave with a specific frequency and a specific digital pattern, the wake-up signal (or command) is monitored using the electrical signal generated by the sound wave reception module 210 (e.g., a piezo sensor), and thus the slave RF nodes can monitor the wake-up signal (or command) even in a low-power state so that there is an effect capable of significantly reducing power consumption, extending the lifetime of the battery, and improving the overall efficiency of the system. The battery may be the battery to which the BMS of the present disclosure is installed.

In addition, the existing wake-up method using RF signals has a problem of being significantly affected by an external environment change due to the characteristics of the RF signals and being disturbed by internal noise. However, in the present invention, since a resonant sound wave with a specified frequency and a specified digital pattern is used, the resonant sound wave has a clear difference from a natural analog pattern so that there is a robust effect against noise and external environment change. In other words, a different transmission technology is used. Accordingly, the signal noise ratio of the sound wave is good. In other words, the signal transmission by the sound wave is reliable with an error rate of less than 99,9%.

In addition, a low-power period is not present in the existing wake-up method using RF signals, but in the present invention, by implementing the sound wave signal pattern in a form including a "wake" period and a "validation" period, in a low-power state, only a signal pattern of the "wake" period is monitored, and when the corresponding signal pattern is detected, the low-power state is changed to recognize a signal pattern of the "validation" period so that there is an effect capable of improving the power efficiency of the entire system by reducing the power consumption of the processor.

Implementations described herein may also be implemented by, for example, a method or process, an apparatus, a software program, a data stream, or a signal. Even when only discussed in the context in a single form of implementation (e.g., discussed only as a method), the implementation of features discussed may also be implemented in other forms (e.g., an apparatus or program). The apparatus may be implemented in suitable hardware, software, and firmware. The method may be implemented in an apparatus such as a processor, which is generally referred to as a processing device including, for example, a computer, a microprocessor, an integrated circuit, or a programmable logic device. Examples of the processor also include communication devices such as computers, cellular phones, portable/personal digital assistants ("PDAs"), and other devices that facilitate information communication of between end-users.

In accordance with the present invention, it is possible to wake up a slave node of a wireless battery management system (BMS) in a standby state using a sound wave.

In addition, in accordance with the present invention, a power consumption optimization function of the wireless BMS can be improved through low-power wake-up using a sound wave.

However, the effects obtainable through the present invention are not limited to the above effects, and other technical effects that are not mentioned will be clearly understood by those skilled in the art from the following description of the present invention.

While the present invention has been described with reference to embodiments shown in the drawings, these embodiments are merely illustrative and it should be understood that various modifications and other equivalent embodiments can be derived by those skilled in the art on the basis of the embodiments. Therefore, the technical scope of the present invention should be defined by the appended claims.

## Claims

1. A wake-up apparatus for a wireless battery management system, comprising:
a master radio frequency RF node (100) configured to output a resonant sound wave with a specified frequency and a specified digital signal pattern; and
a slave radio frequency RF node (200) configured to wake up upon receiving the resonant sound wave output from the master RF node (100).

2. The wake-up apparatus of claim 1, wherein the master RF node (100) comprises a sound wave output module (110) configured to output the resonant sound wave with the specified frequency and the specified digital signal pattern under control of a first processor (120).

3. The wake-up apparatus of claim 1 or 2, wherein the slave RF node (200) comprises a sound wave reception module (210) configured to receive the resonant sound wave output from the master RF node (100).

4. The wake-up apparatus of claim 3, wherein the sound wave reception module (210) is a sensor configured to convert the received resonant sound wave into an electrical signal and output the electrical signal and includes a piezo sensor.

5. The wake-up apparatus of any one of claims 1 to 4, wherein the slave RF node (200) comprises a second processor (220) configured to analyze whether the electrical signal converted from the resonant sound wave received through the sound wave reception module (210) is a wake-up signal for waking up a second RF module (230) of the slave RF node (200).

6. The wake-up apparatus of claim 5, wherein the wake-up signal comprises:
a signal pattern of a first period for releasing a low-power state of the second processor (220) of the slave RF node (200); and
a signal pattern of a second period for wake-up command authentication of the second RF module (230) of the slave RF node (200).

7. The wake-up apparatus of claim 5 or 6, wherein the second processor (220) is configured to:
monitor the signal pattern of the first period of the electrical signal converted from the resonant sound wave received through the sound wave reception module (210) in a low-power state and releases the low-power state when the signal pattern is recognized as a normal pattern; and
monitor the signal pattern of the second period, determine the electrical signal to be the wake-up signal for waking up the second RF module (230) of the slave RF node (200) when the signal pattern is recognized as a normal pattern, and wake up the second RF module (230) of the slave RF node (200).

8. The wake-up apparatus of claim 7, wherein the low-power state includes a low-power mode operating state of the second processor (220) or an operating state using a low-power core.

9. A wake-up method of a wireless battery management system, the method comprising:
outputting (S101), by a master radio frequency RF node (100) of a wireless battery management system, a resonant sound wave with a specified frequency and a specified digital signal pattern; and
receiving (S102), by a slave radio frequency RF node (200), the resonant sound wave output from the master RF node (100) to wake up.

10. The wake-up method of claim 9, wherein, in the outputting of the resonant sound wave, a first processor (120) of the master RF node (100) controls a sound wave output module (110) to output the resonance sound wave with the specified frequency and the specified digital signal pattern.

11. The wake-up method of claim 9 or 10, wherein, in the receiving of the resonant sound wave, a second processor (220) of the slave RF node (200) receives the resonance sound wave output from the master RF node (100) through a sound wave reception module (210).

12. The wake-up method of claim 11, wherein the sound wave reception module (210) is a sensor configured to convert (S103) the received resonant sound wave into an electrical signal and output the electrical signal and includes a piezo sensor.

13. The wake-up method of any one of claims 9 to 12, wherein the receiving of the resonant sound wave to wake up comprises analyzing, by a second processor (220) of the slave RF node (200), whether an electrical signal converted from the resonant sound wave received through the sound wave reception module (210) is a wake-up signal for waking up a second RF module (230) of the slave RF node (200).

14. The wake-up method of claim 13, wherein the wake-up signal comprises:
a signal pattern of a first period for releasing a low-power state of the second processor (220) of the slave RF node (200); and
a signal pattern of a second period for wake-up command authentication of the second RF module (230) of the slave RF node (200).

15. The wake-up method of claim 13 or 14, wherein the receiving of the resonant sound wave to wake up comprises:
monitoring (S201), by the second processor (220), the signal pattern of the first period of the electrical signal converted from the resonant sound wave received through the sound wave reception module (210) in a low-power state and releasing the low-power state when the signal pattern is recognized as a normal pattern (S202); and
monitoring, by the second processor (220), the signal pattern of the second period, determining (S204) the electrical signal to be the wake-up signal for waking up the second RF module (230) of the slave RF node (200) when the signal pattern is recognized as a normal pattern, and waking up (S205) the second RF module (230) of the slave RF node (200).
